Europäisches Patentamt

European Patent Office

Office européen des brevets

(11) Veröffentlichungsnummer: **0 227 966**
**A1**

## (12) EUROPÄISCHE PATENTANMELDUNG

(21) Anmeldenummer: 86116682.5

(22) Anmeldetag: 01.12.86

(51) Int. Cl.4: **H03K 17/95**

(30) Priorität: 12.12.85 DE 3543935

(43) Veröffentlichungstag der Anmeldung:
08.07.87 Patentblatt 87/28

(84) Benannte Vertragsstaaten:
CH DE FR IT LI

(71) Anmelder: **Siemens Aktiengesellschaft Berlin und München**
**Wittelsbacherplatz 2**
**D-8000 München 2(DE)**

(72) Erfinder: **Weigand, Reinhard, Dipl.-Ing. (FH)**
**Rathausstrasse 2**
**D-8451 Ursensollen(DE)**

(54) **Induktiver Näherungsschalter.**

(57) Induktiver Annäherungsschalter, der aus einem Oszillator (2) mit von außen beeinflußbarem Schwingkreis (14,15) sowie einem vom Oszillator steuerbaren Schaltverstärker besteht. Er besitzt weiterhin eine Speiseschaltung für den Oszillator und den Schaltverstärker. Dem Kondensator des Schwingkreises ist die Reihenschaltung eines Kondensators (16) mit einem elektronischen Schalter - (17) parallelgeschaltet und der elektronische Schalter steht in Schaltabhängigkeit zum Ausgang des Schaltverstärkers. Hierdurch wird eine einfache Schalthysterese bewirkt.

EP 0 227 966 A1

## Induktiver Näherungsschalter

Die Erfindung bezieht sich auf einen induktiven Annäherungsschalter, bestehend aus einem Oszillator mit von außen beeinflußbarem Schwingkreis und einem vom Oszillator steuerbaren Schaltverstärker, sowie einer Speiseschaltung für den Oszillator und den Schaltverstärker.

Bei bekannten Näherungsschaltern der obengenannten Art (DE-PS 19 66 178) wird der Schaltabstand über den Emitter-Widerstand des Oszillator-Transistors eingestellt, d.h. dieser Emitter-Widerstand kann von Gerät zu Gerät unterschiedliche Werte einnehmen. Wird diesem Widerstand nun zur Bildung einer Hysterese ein weiterer Widerstand parallelgeschaltet, so ist der Wert der gesamten Parallelschaltung ebenfalls von Gerät zu Gerät unterschiedlich, wenn für den Hysteresewiderstand ein konstanter Widerstand benutzt wird. Dies bedeutet, daß die Hysterese von Gerät zu Gerät bei konstantem Hysterese-Widerstand unterschiedlich sein kann.

Der vorliegenden Erfindung liegt somit die Aufgabe zugrunde, eine Möglichkeit der Hysteresebildung beim induktiven Annäherungsschalter der obengenannten Art zu schaffen, die unabhängig von den Abgleichwerten des Näherungsschalters arbeitet. Dies wird auf einfache Weise dadurch erreicht, wenn dem Kondensator des Schwingkreises die Reihenschaltung eines Kondensators mit einem elektronischen Schalter parallelgeschaltet ist und der elektronische Schalter in Schaltabhängigkeit zum Ausgang des Schaltverstärkers steht. Hierdurch ist es bei Näherungsschaltern, bei denen dem Emitter-Widerstand zur Bildung konstanter Schaltabstände, unabhängig von Temperaturschwankungen, ein weiterer Temperaturkompensationswiderstand parallelgeschaltet ist, möglich, die Hysterese weitgehend konstant zu halten, denn die Temperaturabhängigkeit der Schwingkreiskondensatoren ist wesentlich geringer als die von Widerständen. Bei Verwendung von integrierten Schaltkreisen in induktiven Annäherungsschaltern ist im allgemeinen der Schwingkreis auf der internen Masse angebunden. Hierzu hat sich eine Schaltung als vorteilhaft erwiesen, bei der der elektrische Schalter ein in Emitter-Schaltung betriebener Transistor ist.

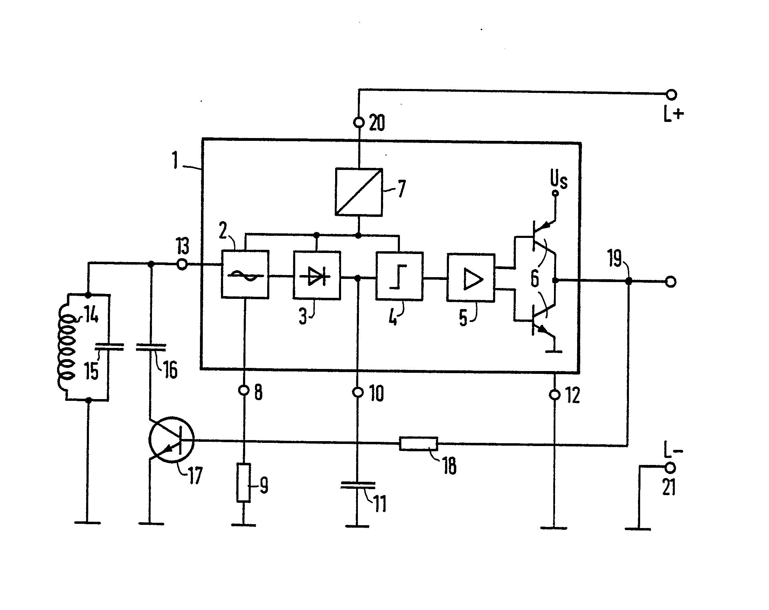

Anhand der Zeichnung wird ein Ausführungsbeispiel gemäß der Erfindung beschrieben.

Der induktive Annäherungsschalter besitzt einen integrierten Schaltkreis 1, in dem der Oszillator 2, ein Gleichrichter 3 sowie ein Schwellenwertschalter 4 und ein Treiber 5 mit Gegentaktendstufe 6 enthalten sind. Der im integrierten Schaltkreis enthaltene Spannungsregler trägt das Bezugszeichen 7. An der Klemme 8 des integrierten Schaltkreises 1 ist der Emitter-Widerstand 9 des Oszillator-Transistors angeschlossen, der mit seiner anderen Seite an Masse liegt. An der Klemme 10, die im integrierten Schaltkreis 1 an der Verbindungsleitung zwischen Gleichrichtung 3 und Schwellenwertschalter 4 angeschlossen ist, ist ein Integrationskondensator 11 gegen Masse angeschaltet. Der Masseanschluß selbst trägt das Bezugszeichen 12. An der Eingangsklemme 13 des integrierten Schaltkreises 1 liegt im integrierten Schaltkreis der Oszillator, und an der Außenseite ist der aus der Induktivität 14 und dem Kondensator 15 bestehende Parallelschwingkreis gegen Masse angeschlossen. Parallel zum Kondensator 15 ist die Reihenschaltung eines Kondensators 16 und der Kollektor-Emitter-Strecke eines Transistors 17 geschaltet. Die Basis des Transistors 17 wird über einen Widerstand 18 vom Ausgang 19 des Näherungsschalters angesteuert. Die Spannungseingangsklemme trägt das Bezugszeichen 20. Sie ist im Ausführungsbeispiel mit der Plusleitung verbunden. Die Minusklemme ist mit 21 bezeichnet. Der induktive Näherungsschalter kann sowohl als Zweidraht-als auch als Mehrdraht-Näherungsschalter betrieben werden.

Zur Funktion des erfindungsgemäßen Näherungsschalters ist folgendes auszuführen: Im unbedämpften Zustand des Näherungsschalters ist der Ausgang 19 leitend, d.h. die Basis des in Emitterschaltung arbeitenden Transistors 17 liegt somit annähernd auf Massepotential. Der Transistor 17 ist somit gesperrt. Bei Annäherung von Metall an den Schwingkreis bzw. an die Induktivität 14 sinkt die Schwingkreisamplitude. Wird ein vorbestimmbarer Amplitudenwert unterschritten, was durch den Schwellenwertschalter erfaßt wird, so reißt die Schwingung ab, d.h. über den Transistor 17 und den Basisvorwiderstand 18 fließt ein Basisstrom, so daß der Transistor 17 leitend wird. Hierdurch wird parallel zum Kondensator 15 der Kondensator 16 geschaltet, wodurch sich die Resonanzfrequenz des Oszillators und somit dessen Empfindlichkeitskurve verändert. Hierdurch ergibt sich die gewünschte Schalthysterese und zwar unabhängig von der Größe des Emitter-Widerstandes 9.

**Ansprüche**

1. Induktiver Annäherungsschalter, bestehend aus einem Oszillator mit von außen beeinflußbarem Schwingkreis und einem vom Oszillator steuerbaren Schaltverstärker, sowie einer Speiseschaltung für den Oszillator und den Schaltverstärker, **dadurch gekennzeichnet**, daß dem Kondensator (15) des Schwingkreises die Reihenschaltung eines Kondensators (16) mit einem elektronischen Schalter (17) parallelgeschaltet ist und der elektronische Schalter (17) in Schaltabhängigkeit zum Ausgang - (19) des Schaltverstärkers (4, 5, 6) steht.

2. Annäherungsschalter nach Anspruch 1, **dadurch gekennzeichnet**, daß der elektronische Schalter (17) ein in Emitter-Schaltung betriebener Transistor ist.

**Europäisches Patentamt**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. 4) |
|---|---|---|---|
| A | DE-A-2 113 556 (W. HOLZER & CO. KG)<br>* Seite 5, Zeile 7 - Seite 12, Zeile 7; Figuren 1-6 * | 1 | H 03 K  17/95 |
| | --- | | |
| A | FR-A-2 110 146 (WEBER)<br>* Seite 2, Zeile 19 - Seite 3, Zeile 38; Figur 1 * | 1 | |
| | --- | | |
| A,D | DE-A-1 966 178 (IFM)<br>* Seite 7, letzter Absatz - Seite 9; Figur * | 1 | |
| | ----- | | |

RECHERCHIERTE SACHGEBIETE (Int. Cl. 4)

H 03 K

Der vorliegende Recherchenbericht wurde für alle Patentansprüche erstellt.

| Recherchenort | Abschlußdatum der Recherche | Prüfer |
|---|---|---|
| DEN HAAG | 20-03-1987 | CANTARELLI R.J.H. |